# EUROPEAN PATENT APPLICATION

(11) **EP 4 832 726 A1**
(43) Date of publication of application: **28.10.2026**
(21) Application number: 24907525.0
(22) Date of filing: 20.12.2024
(51) Int. Cl.: H10N 30/857, B32B 7/025, B32B 27/30, G02B 1/14, G02B 1/18, G06F 3/041, H10N 30/098, H10N 30/30

(54) **LAMINATED PIEZOELECTRIC BODY AND MANUFACTURING METHOD THEREFOR**

(30) Priority: 21.12.2023 JP 2023216252
(71) Applicant: Kureha Corporation, Chuo-ku Tokyo 103-8552 (JP)
(72) Inventor: IMAJI, Makoto, Tokyo 103-8552 (JP)
(74) Representative: Zimmermann & Partner Patentanwälte mbB
(86) International application number: PCT/JP2024/045082
(87) International publication number: WO 2025/135141

(57) **Abstract**

A laminated piezoelectric body includes a piezoelectric film containing a fluorine-based resin as a main component; an antistatic layer disposed on at least one surface of the piezoelectric film; and a moisture-proof layer disposed on a side opposite to the piezoelectric film such that the antistatic layer is interposed between the moisture-proof layer and the piezoelectric film. The laminated piezoelectric body has a water vapor permeability of 0.00 g/m²/day/atm or more and 4.00 g/m²/day/atm or less under an environment of 40°C and 90% RH.

## Description

### TECHNICAL FIELD

The present invention relates to a laminated piezoelectric body and a method for producing the laminated piezoelectric body.

### BACKGROUND ART

There have been proposed various touch input devices in which a touch panel is attached to a display of an electronic device and an operation input is detected by touching an operation surface. As such a touch input device, a three-dimensional touch sensor that performs position detection and pressure detection (a touch sensor that detects a position (2D) and a pressure (1D)) has been proposed.

As the three-dimensional touch sensor, there has been proposed a three-dimensional touch sensor that enables detection of the magnitude of a pressing force at the same time in addition to detection of position coordinates by attaching a pressure sensitive sensor to a touch sensor that detects the position coordinates (see Patent Documents 1 and 2). In such a touch panel, it is required that an image can be visually recognized accurately and detection sensitivity is high, and thus, development of a piezoelectric film having high transparency and a high piezoelectric constant is expected.

As the piezoelectric film, there is known a piezoelectric film containing a polymer material such as polylactic acid or a fluorine-based resin. A piezoelectric film containing a polymer material is excellent in transparency, but is likely to be charged by friction or vibration during transportation, and static electricity is likely to be generated. Due to this, the static electricity itself or the adsorption of dust to the piezoelectric film due to the static electricity is likely to cause appearance failure or a decrease in performance of the piezoelectric device. To solve these problems, a piezoelectric body in which an antistatic layer is laminated on a piezoelectric film containing polylactic acid has been proposed (see Patent Document 3).

Among piezoelectric films containing a polymer material, a piezoelectric film containing a fluorine-based resin not only has a higher piezoelectric constant as compared with a piezoelectric film containing polylactic acid, but also is likely to be piezoelectrically polarized in the same direction as the stress direction. Thus, the piezoelectric film containing a fluorine-based resin is more suitable for a touch panel.

### CITATION LIST

### PATENT DOCUMENT

Patent Document 1: JP 2010-26938 A
Patent Document 2: WO 2010/102635
Patent Document 3: WO 2016/098597

### SUMMARY OF INVENTION

### TECHNICAL PROBLEM

Touch panels are used under various environments. For example, when a touch panel is assumed to be used in an in-vehicle application such as a car navigation system, the touch panel is required to maintain high transparency even under high temperature and high humidity.

However, it has been found that when a laminated piezoelectric body in which an antistatic layer is laminated on a piezoelectric film containing a fluorine-based resin is used under high temperature and high humidity, the piezoelectric film is likely to be discolored over time, and the transparency is lowered.

The present invention has been made in view of the above circumstances, and an object of the present invention is to provide a laminated piezoelectric body which suppresses discoloration of a piezoelectric film under high temperature and high humidity and can maintain high transparency, and a method for producing the laminated piezoelectric body.

### SOLUTION TO PROBLEM

[1] A laminated piezoelectric body including: a piezoelectric film containing a fluorine-based resin as a main component; an antistatic layer disposed on at least one surface of the piezoelectric film; and a moisture-proof layer disposed on a side opposite to the piezoelectric film such that the antistatic layer is interposed between the moisture-proof layer and the piezoelectric film, wherein the laminated piezoelectric body has a water vapor permeability of 0.00 g/m²/day/atm or more and 4.00 g/m²/day/atm or less under an environment of 40°C and 90% RH.
[2] The laminated piezoelectric body according to [1], wherein no adhesive layer is disposed between the antistatic layer and the moisture-proof layer.
[3] The laminated piezoelectric body according to [1] or [2], wherein the antistatic layer contains a cured product of a curable composition containing a conductive material and an amine-based material.
[4] The laminated piezoelectric body according to any of [1] to [3], wherein the moisture-proof layer is formed of an inorganic oxide.
[5] The laminated piezoelectric body according to any of [1] to [4], further including at least one of a hard coat layer or optical adjustment layer disposed between the antistatic layer and the moisture-proof layer.
[6] The laminated piezoelectric body according to [5], wherein a total thickness of the hard coat layer and the optical adjustment layer is 0.30 µm or more and 4.0 µm or less.
[7] The laminated piezoelectric body according to any of [1] to [6], wherein when the laminated piezoelectric body is held under an environment of 85°C and 85% RH for 500 hours, a hue difference Δb^{*} before and after the holding under the environment is 4.0 or less.
[8] The laminated piezoelectric body according to any of [1] to [7], wherein the antistatic layer has a thickness of 0.010 µm or more and 0.40 µm or less.
[9] The laminated piezoelectric body according to any of [1] to [8], wherein the fluorine-based resin contains a polymer containing a constituent unit derived from vinylidene fluoride as a main component.
[10] A method for producing the laminated piezoelectric body described in any of [1] to [9], the method including applying a curable composition containing a conductive material and an amine-based material onto the piezoelectric film and then curing the curable composition to form an antistatic layer, and forming a moisture-proof layer on the antistatic layer by reactive sputtering.

### ADVANTAGEOUS EFFECTS OF INVENTION

According to the present invention, it is possible to provide a laminated piezoelectric body in which discoloration of a piezoelectric film is small even under high temperature and high humidity, and high transparency can be maintained, and a method for producing the laminated piezoelectric body.

### BRIEF DESCRIPTION OF DRAWINGS

FIG. 1 is a schematic cross-sectional view illustrating a laminated piezoelectric body according to a present embodiment.
FIGS. 2A and 2B are schematic cross-sectional views, each illustrating a laminated piezoelectric body according to another embodiment.
FIG. 3 is a schematic cross-sectional view illustrating a laminated piezoelectric body according to another embodiment.

### DESCRIPTION OF EMBODIMENTS

As described above, it has been found that when a laminated piezoelectric body including a piezoelectric film containing a fluorine-based resin and an antistatic layer is used under high temperature and high humidity, the piezoelectric film is discolored.

This mechanism is not clear, but is estimated as follows. In a laminated piezoelectric body including an antistatic layer, a base such as an amine may be generated due to, for example, decomposition of a constituent material of the antistatic layer or the like. In the fluorine-based resin contained in the piezoelectric film, when the fluorine-based resin is brought into contact with a base under a high temperature and high humidity environment, dehydrofluorination reaction proceeds, and a conjugated double bond is likely to be formed in a molecule. Due to this, the piezoelectric film containing the fluorine-based resin is likely to be discolored to a yellowish color.

With regard to this, the present inventor has found that when a moisture-proof layer is provided on an antistatic layer directly or via another layer, the dehydrofluorination reaction due to contact between the fluorine-based resin and the base can be suppressed, which makes it possible to suppress the discoloration of the piezoelectric film. Accordingly, it is possible to produce a laminated piezoelectric body in which the discoloration of the piezoelectric film is small and high transparency can be maintained even when the laminated piezoelectric body is stored under high temperature and high humidity. Hereinafter, the laminated piezoelectric body of the present invention will be specifically described.

### 1. Laminated Piezoelectric Body

The laminated piezoelectric body includes a piezoelectric film, an antistatic layer, and a moisture-proof layer. The laminated piezoelectric body may further include an additional layer such as a hard coat layer or an optical adjustment layer, as necessary, from the viewpoint of preventing the antistatic layer from being scratched and adjusting the hue. However, from the viewpoint of further suppressing discoloration of the piezoelectric film, it is preferable that the laminated piezoelectric body does not include a layer (e.g., an adhesive layer) into which moisture easily penetrates from the outside between the antistatic layer and the moisture-proof layer on the surface side of the piezoelectric film on which the antistatic layer is disposed.

Hereinafter, a laminated piezoelectric body according to an embodiment of the present invention and a method for producing the same will be specifically described.

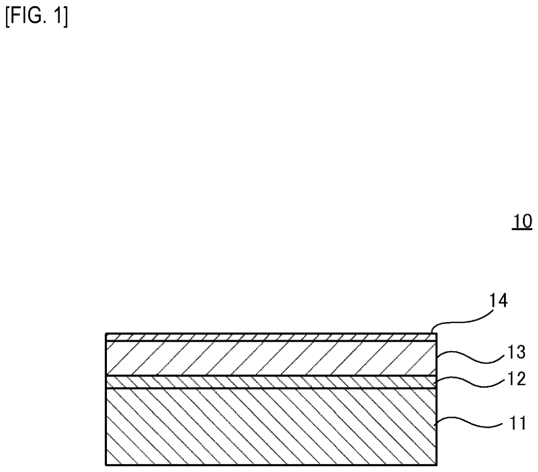

FIG. 1 is a schematic cross-sectional view illustrating a laminated piezoelectric body 10 according to the present embodiment.
As illustrated in FIG. 1, the laminated piezoelectric body 10 according to the present embodiment includes a piezoelectric film 11, an antistatic layer 12, a hard coat layer 13, and a moisture-proof layer 14.

### 1-1. Piezoelectric Film 11

The piezoelectric film contains a fluorine-based resin as a main component. The expression "containing a fluorine-based resin as a main component" means that the content of a fluorine-based resin contained in the piezoelectric film is 50 mass% or more, and preferably 60 mass% or more.

In particular, the fluorine-based resin is preferably a polymer containing a constituent unit derived from vinylidene fluoride from the viewpoint of easily achieving a high piezoelectric effect.

The content of the constituent unit derived from vinylidene fluoride in the polymer is preferably 50 mass% or more and 100 mass% or less, more preferably 70 mass% or more and 100 mass% or less, still more preferably 80 mass% or more and 100 mass% or less, and particularly preferably 90 mass% or more and 100 mass% or less, relative to the total amount of constituent units of the polymer. As the content of the constituent unit derived from vinylidene fluoride is larger, a higher piezoelectric effect is more likely to be achieved.

The polymer may further include a constituent unit derived from a monomer copolymerizable with vinylidene fluoride as long as the effects of the present invention are not impaired. Examples of the monomer copolymerizable with vinylidene fluoride include fluorine-containing monomers, such as trifluoroethylene, tetrafluoroethylene, hexafluoropropylene, chlorotrifluoroethylene, and vinyl fluoride. Two or more types of these monomers may be contained.

Among these, a homopolymer of vinylidene fluoride is preferred, from the viewpoint of easily increasing a piezoelectric constant d₃₃ of the piezoelectric film and more easily achieving the piezoelectric effect.

The piezoelectric film preferably has a piezoelectric constant d₃₃ of 7 pC/N or more and 40 pC/N or less. When the piezoelectric constant d₃₃ of the piezoelectric film is 7 pC/N or more, the amount of charge to be generated by the piezoelectric effect is larger, and thus pressure sensitivity can be further enhanced. When the piezoelectric constant d₃₃ of the piezoelectric film is 40 pC/N or less, it is possible to further reduce appearance failure due to a decrease in flatness of the surface of the piezoelectric film caused by, for example, a polarization treatment. From the same viewpoint, the piezoelectric constant d₃₃ of the piezoelectric film is more preferably 10 pC/N or more and 40 pC/N or less, still more preferably 13 pC/N or more and 35 pC/N or less, and particularly preferably 15 pC/N or more and 30 pC/N or less.

The piezoelectric constant d₃₃ of the piezoelectric film can be measured in accordance with ISO 19622:2018, which is a test method for a piezoelectric constant d₃₃ of piezoelectric ceramics by a direct quasi-static method (d₃₃ meter method, Berlincourt method). Specifically, a sample is clipped at 1.0 N, and a charge generated under application of a force of 0.15 N and 110 Hz is read using a piezoelectric constant measuring device (e.g., PiezoMeter System PM300, available from PIEZOTEST Pte Ltd.), whereby the measurement can be performed.

The piezoelectric constant d₃₃ of the piezoelectric film can be adjusted mainly by the type of the resin contained in the piezoelectric film and production conditions (conditions for the polarization treatment and the stretching treatment). For example, the piezoelectric constant d₃₃ of the piezoelectric film is likely to be increased when the piezoelectric film contains, among fluorine-based resins, a resin containing a larger amount of a constituent unit derived from vinylidene fluoride. The piezoelectric constant d₃₃ of the piezoelectric film is likely to be increased by strengthening the polarization treatment or the stretching treatment.

The thickness of the piezoelectric film can be adjusted by the film formation conditions and the stretching ratio of the resin film. The thickness of the piezoelectric film is preferably, for example, 25 µm or more and 120 µm or less. When the thickness of the piezoelectric film is 25 µm or more, the amount of charge to be generated by a piezoelectric effect is further increased, and higher piezoelectricity is easily achieved. The thickness of the piezoelectric film is more preferably 30 µm or more and still more preferably 35 µm or more. When the thickness of the piezoelectric film is 120 µm or less, the transparency of the piezoelectric film is less likely to be impaired. The thickness is more preferably 100 µm or less, and still more preferably 80 µm or less. From the same viewpoint, the thickness of the piezoelectric film is more preferably 35 µm or more and 80 µm or less.

### 1-2. Antistatic Layer 12

The antistatic layer is disposed on at least one surface of the piezoelectric film. In the present embodiment, the antistatic layer is disposed on one surface of the piezoelectric film (see FIG. 1). The antistatic layer is preferably in contact with the piezoelectric film. The antistatic layer can make it difficult for static electricity to be generated in the laminated piezoelectric body.

The antistatic layer can contain a cured product of a curable composition containing a conductive material. The curable composition containing a conductive material may contain a conductive material, a curable resin, and optionally a crosslinking agent, or may contain a conductive material and a crosslinking agent.

The conductive material may be an ion conduction type conductive material or an electron conduction type conductive material.

Examples of the ion conduction type conductive material include (a) cationic antistatic agents having a cationic group, such as a quaternary ammonium salt, a pyridinium salt, or a primary to tertiary amino group; (b) anionic antistatic agents having an anionic group, such as a sulfonate group, a sulfate ester salt group, a phosphate ester salt group, or a phosphonate group; (c) amino acid-based and amino sulfate-based amphoteric antistatic agents; and (d) amino alcohol-based, glycerin-based, and polyethylene glycol-based nonionic antistatic agents.

Examples of the electron conduction type conductive material include a conductive polymer and other conductive materials. Examples of the conductive polymer include polyacetylene or a derivative thereof, polythiophene or a derivative thereof, polypyrrole or a derivative thereof, and polyaniline or a derivative thereof. Among these, polythiophene or a derivative thereof is preferred from the viewpoint that the transparency is high and high conductivity is exhibited. These conductive polymers may have a functional group such as a sulfone group, an amino group, an amide group, a hydroxyl group, a mercapto group, or a carboxyl group. Examples of the conductive materials other than the conductive polymer include carbon nanotube and graphene.

Among these, from the viewpoint of easily lowering the surface resistivity of the laminated piezoelectric body and hardly causing bleed-out, it is preferable to include an electron conduction type conductive material, and carbon nanotube is more preferred.

Examples of the curable resin include an acrylic resin, an epoxy resin, a polyurethane resin, a polyimide resin, a melamine resin, a polyester resin, a polyvinyl alcohol resin, a polystyrene resin, a polyvinyl acetate resin, a silicone compound, and polyethylene glycol, each having a functional group such as a hydroxy group, a methylol group, a carboxyl group, a sulfonyl group, an epoxy group, or an amino group.

The crosslinking agent only needs to be an agent that reacts with a functional group of a curable resin or a conductive polymer to crosslink the curable resin or the conductive polymer. Examples of the crosslinking agent include a melamine-based crosslinking agent, a polycarbodiimide-based crosslinking agent, a polyoxazolidine-based crosslinking agent, a polyepoxy-based crosslinking agent, and a polyisocyanate-based crosslinking agent.

As described above, in some cases, a curable resin or a crosslinking agent having an amino group, such as a melamine resin (these are also referred to as "amine-based materials") is used as the curable resin or the crosslinking agent for forming the antistatic layer. Among them, a melamine resin is preferably used in some cases from the viewpoint of having low-temperature curability. Meanwhile, such an amine-based material easily generates an amine (base) that causes a dehydrofluorination reaction of the fluorine-based resin under high temperature and high humidity, and particularly easily causes discoloration of the piezoelectric film. Even in such a case, the discoloration of the piezoelectric film in the laminated piezoelectric body can be suppressed by providing the moisture-proof layer described above.

The surface resistivity of the antistatic layer is, for example, preferably 1.0 × 10⁴ Ω/sq or more and 1.0 × 10⁹ Ω/sq or less, and more preferably 1.0 × 10⁵ Ω/sq or more and 1.0 × 10⁸/sq or less. When the surface resistivity of the antistatic layer is 1.0 × 10⁹ Ω/sq. or less, the surface resistivity of the laminated piezoelectric body can be further lowered, and the antistatic property is sufficiently imparted. The surface resistivity can be measured in accordance with JIS K 6911 by using a known resistivity meter (e.g., a high resistivity meter (available from Nittoseiko Analytech Co., Ltd., Hiresta-UX, model number: MCP-HT800, URS probe).

The thickness of the antistatic layer is not particularly limited and is, for example, preferably 0.010 µm or more and 0.40 µm or less. By setting the thickness of the antistatic layer to 0.010 µm or more, generation of static electricity in the laminated piezoelectric body can be further suppressed. When the thickness of the antistatic layer is 0.40 µm or less, discoloration of the piezoelectric film in the laminated piezoelectric body can be made less likely to occur. From the same viewpoint, the thickness of the antistatic layer is more preferably 0.030 µm or more and 0.40 µm or less, and still more preferably 0.045 µm or more and 0.30 µm or less.

The thickness of the antistatic layer can be measured using a spectral interference-type thickness meter (e.g., Optical NanoGauge C13027-11, available from Hamamatsu Photonics K.K.). The thickness of each layer in a region including the center of the surface of the laminated piezoelectric body is measured at three points, and the arithmetic average value thereof can be determined as the thickness of each layer. The thickness of each of the following layers can be measured by the same method.

### 1-3. Hard Coat Layer 13

The hard coat layer is preferably disposed between the antistatic layer and the moisture-proof layer. The hard coat layer can suppress an increase in haze by making the surface of the antistatic layer less likely to be scratched during the production of the laminated piezoelectric body. Only one hard coat layer may be included, or two or more hard coat layers may be included. In a case where two or more hard coat layers are included, one of the two or more hard coat layers may be disposed on one surface side of the piezoelectric film, and the other one thereof may be disposed on the other surface side.

The hard coat layer preferably contains a cured product of a curable composition containing a polymerizable compound.

### Polymerizable Compound

The polymerizable compound may be any of a monomer, an oligomer, or a polymer. The polymerizable compound may be a thermosetting compound or an ionizing radiation compound, but is preferably an ionizing radiation compound. The ionizing radiation may typically be ultraviolet rays (UV) or an electron beam (EB).

The ionizing radiation compound is a compound having an ionizing radiation-curable functional group. Examples of the ionizing radiation-curable functional group include ethylenically unsaturated bond groups such as a (meth)acryloyl group, a vinyl group, and an allyl group, and ring-opening polymerizable groups such as an epoxy group and an oxetanyl group. Among them, a compound having an ethylenically unsaturated bond group is preferable, a compound having two or more ethylenically unsaturated bond groups is more preferable, and a polyfunctional (meth)acrylate-based compound is still more preferable. The term "(meth)acrylate" means one or both of acrylate and methacrylate.

Examples of a bifunctional (meth)acrylate-based monomer among the polyfunctional (meth)acrylate-based compounds include ethylene glycol di(meth)acrylate, bisphenol A tetraethoxy diacrylate, bisphenol A tetrapropoxy diacrylate, and 1,6-hexanediol diacrylate. Examples of the (meth)acrylate-based monomer having three or more functional groups include trimethylolpropane tri(meth)acrylate, pentaerythritol tri(meth)acrylate, pentaerythritol tetra(meth)acrylate, dipentaerythritol hexa(meth)acrylate, dipentaerythritol tetra(meth)acrylate, and isocyanuric acid-modified tri(meth)acrylate. The (meth)acrylate-based monomer may be one in which a part of the molecular skeleton is modified, or one modified with ethylene oxide, propylene oxide, caprolactone, isocyanuric acid, alkyl, cyclic alkyl, aromatic, bisphenol, or the like can also be used.

Examples of the polyfunctional (meth)acrylate-based oligomer include acrylate-based polymers such as urethane (meth)acrylate, epoxy (meth)acrylate, polyester (meth)acrylate, and polyether (meth)acrylate. Urethane (meth)acrylate is obtained, for example, by reacting a polyhydric alcohol and an organic diisocyanate with hydroxy (meth)acrylate.

### Polymerization Initiator

In a case where the ionizing radiation-curable compound is an ultraviolet-curable compound, the curable composition preferably contains a photopolymerization initiator. Examples of the photopolymerization initiator include one or more selected from acetophenone, benzophenone, α-hydroxyalkylphenone, Michler's ketone, benzoin, benzyl methyl ketal, benzoyl benzoate, α-acyloxime ester, and thioxanthones.

### Additional Component

The curable composition may further contain an additional component other than the above components as necessary. For example, the curable composition may further contain particles from the viewpoint of suppressing blocking during the production of the laminated piezoelectric body or adjusting the refractive index. The particles may be inorganic particles or organic particles.

Examples of the inorganic particles include particles of silica (silicon oxide), titanium oxide, zirconium oxide, aluminum oxide, zinc oxide, tin oxide, and the like, diamond powder, sapphire particles, boron carbide particles, silicon carbide particles, and antimony pentoxide particles. Examples of the organic particles include resin particles of an acrylic resin, an acrylic-styrene copolymer, and a silicone resin. Among them, inorganic particles are preferable, and silica particles are more preferable, from the viewpoint of further suppressing a decrease in transparency of the hard coat layer. The surface of the inorganic particles may be treated with a surface modifier such as a silane coupling agent.

The thickness of the hard coat layer is not particularly limited, but is, for example, 0.05 µm or more, preferably 0.3 µm or more and 3.0 µm or less, more preferably 0.5 µm or more and 2.0 µm or less, and still more preferably 0.5 µm or more and 1.5 µm or less.

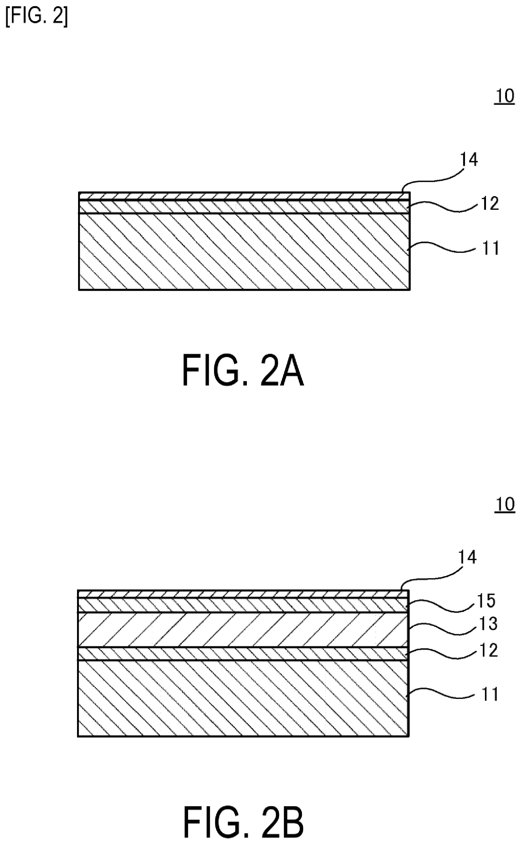

As described below, the laminated piezoelectric body may further include an optical adjustment layer between the antistatic layer and the moisture-proof layer (see FIG. 2B described below). The total thickness of the hard coat layer and the optical adjustment layer is preferably 0.30 µm or more and 4.0 µm or less. When the total thickness is 4.0 µm or less, the penetration of moisture from the outside through these layers can be further suppressed, and the effect of suppressing the discoloration of the piezoelectric film by providing the moisture-proof layer is more likely to be maintained. When the total thickness is 0.30 µm or more, the color tone of the laminated piezoelectric body can be further improved, and the transparency can be further enhanced. From the same viewpoint, the total thickness is more preferably 0.50 µm or more and 3.0 µm or less, and still more preferably 0.60 µm or more and 2.0 µm or less.

### 1-4. Moisture-Proof Layer 14

The moisture-proof layer is disposed on the side opposite to the piezoelectric film with the antistatic layer interposed therebetween. In the present embodiment, the moisture-proof layer is disposed on the hard coat layer (see FIG. 1). The moisture-proof layer can suppress the penetration of moisture that causes discoloration of the piezoelectric film. One moisture-proof layer may be included, or two or more moisture-proof layers may be included. In a case where two or more moisture-proof layers are included, one of the two or more moisture-proof layers may be disposed on one surface side of the piezoelectric film, and the other one thereof may be disposed on the other surface side.

The material constituting the moisture-proof layer is not particularly limited as long as it has transparency and can suppress the penetration of moisture. For example, the moisture-proof layer is preferably formed of an inorganic oxide, and more preferably a thin film (such as a vapor deposition film) of an inorganic oxide.

The inorganic oxide refers to an oxide of a metal, an oxide of a non-metal, or an oxide of a sub-metal. Examples of the inorganic oxide include aluminum oxide, zinc oxide, antimony oxide, indium oxide, indium tin oxide, calcium oxide, cadmium oxide, silver oxide, gold oxide, chromium oxide, silicon oxide, cobalt oxide, zirconium oxide, tin oxide, titanium oxide, iron oxide, copper oxide, nickel oxide, platinum oxide, palladium oxide, bismuth oxide, magnesium oxide, manganese oxide, molybdenum oxide, vanadium oxide, and barium oxide, and indium tin oxide and silicon oxide are particularly preferable.

The thickness of the moisture-proof layer is not particularly limited, but is preferably 0.005 µm or more and 0.100 µm or less, more preferably 0.010 µm or more and 0.060 µm or less, and still more preferably 0.015 µm or more and 0.050 µm or less, from the viewpoint of more highly achieving both moisture-proof property and transparency.

### 1-5. Physical Properties of Laminated Piezoelectric Body 10

### Water Vapor Permeability

The laminated piezoelectric body can suppress permeation of moisture by including the moisture-proof layer. Specifically, the water vapor permeability of the laminated piezoelectric body under an environment of 40°C and 90% RH is 0.00 g/m²/day/atm or more and 4.00 g/m²/day/atm or less, preferably 0.00 g/m²/day/atm or more and 2.00 g/m²/day/atm or less, more preferably 0.05 g/m²/day/atm or more and 2.00 g/m²/day/atm or less, and particularly preferably 0.05 g/m²/day/atm or more and 1.00 g/m²/day/atm or less. When the water vapor permeability of the laminated piezoelectric body is 4.00 g/m²/day/atm or less, the penetration of moisture into the laminated piezoelectric body can be reduced, and thus, the discoloration of the piezoelectric film can be suppressed. When the water vapor permeability of the laminated piezoelectric body is 0.05 g/m²/day/atm or more, the thickness of the moisture-proof layer can be made smaller, and the coloration caused by the inorganic compound contained in the moisture-proof layer can be further suppressed.

The water vapor permeability of the laminated piezoelectric body can be measured under the condition of 40°C and 90% RH using a water vapor permeability measurement device, based on JIS K7129-2.

The water vapor permeability of the laminated piezoelectric body can be adjusted by the layer configuration, and the composition or thickness of the moisture-proof layer. For example, when a hard coat layer or an optical adjustment layer is further provided between the antistatic layer and the moisture-proof layer, the water vapor permeability is likely to decrease. When the thickness of the moisture-proof layer is increased, the water vapor permeability is likely to decrease.

### b^{*} Value, Δb^{*}

The b^{*} value of the laminated piezoelectric body before storage is preferably, for example, -5.0 or more and 5.0 or less. The hue difference Δb^{*} before and after storage of the laminated piezoelectric body under an environment of 85°C and 85% RH for 500 hours is preferably 4.0 or less, and more preferably 3.5 or less. When Δb^{*} before and after the storage of the laminated piezoelectric body is 4.0 or less, a change in hue of the laminated piezoelectric body under high temperature and high humidity is small, and thus the transparency and visibility can be favorably maintained.

The b^{*} value of the laminated piezoelectric body can be measured by a method in accordance with JIS Z 8722 using a spectral colorimeter (e.g., SD7000, available from Nippon Denshoku Industries Co., Ltd.).
The b^{*} value of the laminated piezoelectric body after the storage only needs to be measured by cutting out the laminated piezoelectric body into a square of 25 cm², fixing the four corners of the laminated piezoelectric body to a plate made of SUS with a tape, placing the laminated piezoelectric body in a thermo-hygrostat set to a temperature of 85°C and a humidity of 85% RH, holding the laminated piezoelectric body for 500 hours under the above conditions, and then measuring the b^{*} value of the laminated piezoelectric body taken out from the thermo-hygrostat in the same manner as the above method.

The b^{*} value and Δb^{*} of the laminated piezoelectric body can be adjusted by the thickness of the antistatic layer and the composition and thickness of the moisture-proof layer. For example, when the thickness of the antistatic layer is reduced, the b^{*} value and Δb^{*} can be reduced. When the thickness of the moisture-proof layer is increased, discoloration of the piezoelectric film due to the penetration of moisture can be reduced, and the b^{*} value and Δb^{*} can be reduced.

### Piezoelectric Constant

The piezoelectric constant d₃₃ of the laminated piezoelectric body is preferably, for example, 7 pC/N or more and 40 pC/N or less. When the piezoelectric constant d₃₃ of the laminated piezoelectric body is 7 pC/N or more, high pressure sensitivity is likely to be achieved. When the piezoelectric constant d₃₃ of the laminated piezoelectric body is 40 pC/N or less, the above-described appearance failure can be further reduced. From the same viewpoint, the piezoelectric constant d₃₃ of the laminated piezoelectric body is more preferably 10 pC/N or more and 40 pC/N or less, still more preferably 13 pC/N or more and 35 pC/N or less, and particularly preferably 15 pC/N or more and 30 pC/N or less. The piezoelectric constant d₃₃ of the laminated piezoelectric body can be measured by the same method as described above.

The piezoelectric constant d₃₃ of the laminated piezoelectric body can be adjusted by, for example, the piezoelectric constant d₃₃ of the piezoelectric film, which is one of the components of the laminated piezoelectric body. When the piezoelectric constant d₃₃ of the piezoelectric film is high, the piezoelectric constant d₃₃ of the laminated piezoelectric body is also likely to be high.

### Total Light Transmittance

The laminated piezoelectric body preferably has high transparency from the viewpoint of being applied to a touch panel, for example. Specifically, the total light transmittance of the laminated piezoelectric body is preferably 80% or more, and more preferably 85% or more.

The total light transmittance of the laminated piezoelectric body can be measured using a haze meter (e.g., NDH7000SP II, available from Nippon Denshoku Industries Co., Ltd.) based on the method described in JIS K 7361-1.

The total light transmittance of the laminated piezoelectric body can be adjusted by the layer configuration, and the refractive index and thickness of each layer. For example, when the laminated piezoelectric body includes a hard coat layer, the haze of the laminated piezoelectric body can be further reduced, and thus the total light transmittance is likely to be higher.

### 2. Method for Producing Laminated Piezoelectric Body

The laminated piezoelectric body can be produced by any method. For example, the laminated piezoelectric body of FIG. 1 can be produced through (1) a step of providing a piezoelectric film containing a fluorine-based resin, (2) a step of forming an antistatic layer on the piezoelectric film, (3) a step of forming a hard coat layer on the antistatic layer, and (4) a step of forming a moisture-proof layer on the hard coat layer. In a case where the laminated piezoelectric body does not include a hard coat layer, the step (3) can be omitted.

### (1) Step of Providing Piezoelectric Film

The piezoelectric film containing a fluorine-based resin may be a preliminarily produced film or may be newly produced. For example, the piezoelectric film containing a fluorine-based resin can be provided through a step of producing a film containing a fluorine-based resin (film production step), a step of stretching the film containing the fluorine-based resin (stretching step), and a step of polarization treatment (polarization step).

### Film Production Step

The film containing a fluorine-based resin can be produced by any method such as a melt extrusion method, a hot press method, or a solution casting method. In particular, from the viewpoint of easily producing a piezoelectric film having a thickness equal to or greater than a predetermined value, the film containing a fluorine-based resin is preferably produced by the melt-extrusion method.

### Stretching Step

In the stretching step, the produced film containing a fluorine-based resin is stretched. The film containing a fluorine-based resin has a structure in which an α-type crystal (the main chain has a helical structure) and a β-type crystal (the main chain has a planar zigzag structure) are mixed. The β-type crystal has a large polarization structure. When the film containing the fluorine-based resin is stretched, the α-type crystal is transformed into the β-type crystal, and the proportion of the β-type crystal can be increased. Thus, the stretching step is preferably performed, as necessary, to increase the proportion of the β-type crystal of the fluorine-based resin. The stretching direction may be a TD direction or an MD direction, and is more preferably the MD direction.

The stretching method is not particularly limited, and can be performed by a known stretching method such as a tenter method or a drum method.

The stretching ratio may be, for example, 3.0 times or more and 6.0 times or less. When the stretching ratio is 3.0 times or more, it is easy to adjust the thickness and polarizability of the film to fall within more appropriate ranges. When the stretching ratio is 3.0 times or more, dislocation of the β-type crystal further proceeds, and not only higher piezoelectricity is likely to be exhibited, but also transparency can be further enhanced. When the stretching ratio exceeds 6.0 times, the film may be broken by stretching, which is not preferable.

### Polarization Step

In the polarization step, a DC voltage is applied to the fluorine-based resin film to impart piezoelectricity to the fluorine-based resin film. Thus, when a DC voltage is applied to the fluorine-based resin film in which the proportion of the β-type crystal having polarity is increased in the stretching step, a piezoelectric film having high piezoelectricity can be produced. The DC voltage to be applied only needs to be adjusted depending on the thickness of the stretched film, and can be, for example, 1 kV or more and 50 kV or less.

### (2) Step of Forming Antistatic Layer

The curable composition for an antistatic layer described above is applied onto the produced piezoelectric film, and then dried and cured to form an antistatic layer. From the viewpoint of enhancing the low-temperature curability, the curable composition for an antistatic layer is preferably a curable composition containing a conductive material and an amine-based material, and more preferably a curable composition containing a conductive material and a melamine resin.

The curable composition may further contain water or a solvent. Examples of the solvent include alcohol-based solvents such as methanol, ethanol, and isopropyl alcohol.

The method for applying the curable composition is not particularly limited, and may be any of a spin coating method, a gravure coating method, a die coating method, a bar coating method, a dip coating method, and the like.

The drying of the curable composition can be performed by heating the applied curable composition. The heating temperature is preferably a temperature equal to or higher than a temperature at which the solvent can be removed and equal to or lower than the thermal deformation temperature of the fluorine-based resin constituting the piezoelectric film, and can be set to, for example, 100°C or higher and 150°C or lower. The thermal deformation temperature can be measured, for example, in accordance with JIS K 7191-2:2015.

### (3) Step of Forming Hard Coat Layer

The curable composition for a hard coat layer described above is applied onto the formed antistatic layer, and then dried and cured to form a hard coat layer.

The curable composition may further contain a diluting solvent. The diluting solvent is preferably a solvent having a polarity close to that of the particles. Examples of the diluting solvent include organic solvents such as an alcohol-based solvent, a ketone-based solvent, an ester-based solvent, a carbonate-based solvent, and an aromatic solvent.

The method for applying and drying the curable composition can be the same as the application and drying method described above. The heating temperature may be a temperature equal to or lower than the thermal deformation temperature of the fluorine-based resin constituting the piezoelectric film within a range in which the solvent can be volatilized and removed, and can be, for example, 60°C or higher and 100°C or lower.

The curing of the curable composition may be performed by heat or may be performed by ionizing radiation. The curing by ionizing radiation can be performed by irradiation with ultraviolet rays or an electron beam. Curing by heat and curing by ionizing radiation may be used in combination.

### (4) Step of Forming Moisture-Proof Layer

A moisture-proof layer is formed on the formed antistatic layer.

The method for forming the moisture-proof layer is not particularly limited, and examples thereof include a vapor deposition method (dry process method). The vapor deposition method may be a physical vapor deposition method (PVD) such as vacuum vapor deposition, sputtering, or ion plating, or may be a chemical vapor deposition method (CVD). Among these, vacuum vapor deposition or sputtering is preferable, and reactive sputtering is more preferable from the viewpoint of easily forming a thin film containing an oxide or a nitride.

### 3. Applications

The laminated piezoelectric body can be used for various applications. In particular, the laminated piezoelectric body exhibits high piezoelectricity while having high transparency and visibility, and thus can be preferably used as a piezoelectric sensor of a touch panel mounted on various electronic devices.

### 4. Modification

In the above-described embodiment, an example in which the laminated piezoelectric body has the layer configuration illustrated in FIG. 1 has been described, but the layer configuration of the laminated piezoelectric body is not limited thereto.

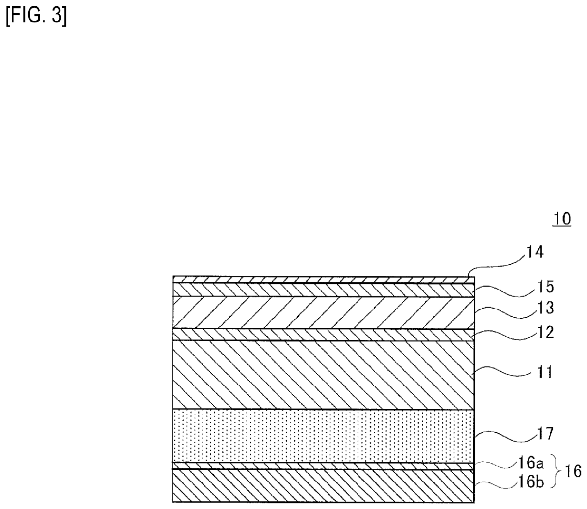

FIGS. 2A, 2B and 3 are schematic cross-sectional views illustrating laminated piezoelectric bodies according to other embodiments.

As illustrated in FIG. 2A, the laminated piezoelectric body 10 need not include the hard coat layer 13. That is, another layer need not be included between the antistatic layer 12 and the moisture-proof layer 14.

The laminated piezoelectric body 10 may further include another layer instead of the hard coat layer 13 or in addition to the hard coat layer 13. For example, as illustrated in FIG. 2B, the laminated piezoelectric body 10 may further include an optical adjustment layer 15.

The optical adjustment layer 15 is preferably disposed between the antistatic layer and the moisture-proof layer (see FIG. 2B). In FIG. 2B, the optical adjustment layer is disposed between the hard coat layer and the moisture-proof layer. The optical adjustment layer can further improve the color tone of the laminated piezoelectric body by appropriately adjusting the refractive index and the thickness. Only one optical adjustment layer may be included, or two or more optical adjustment layers may be included. For example, in a case where two or more optical adjustment layers are included, one of the two or more optical adjustment layers may be disposed on one surface side of the piezoelectric film, and the other one thereof may be disposed on the other surface side.

The refractive index of the optical adjustment layer is preferably higher than the refractive index of the antistatic layer and lower than the refractive index of the moisture-proof layer. In FIG. 2B, the refractive index of the optical adjustment layer is preferably higher than the refractive index of the hard coat layer and lower than the refractive index of the moisture-proof layer. The laminated piezoelectric body including such an optical adjustment layer can further suppress appearance failure due to an interference action between light incident on and reflected by the hard coat layer and light reflected at the interface between the optical adjustment layer and the hard coat layer.

From the above viewpoint, the refractive index of the optical adjustment layer is preferably 1.60 or more and less than 1.80, more preferably 1.63 or more and less than 1.78, and still more preferably 1.65 or more and 1.75 or less.

In the present specification, the refractive index means a refractive index at a wavelength of 589 nm. The refractive index of the optical adjustment layer can be determined by measuring psi (Ψ) and delta (Δ) with a multi-incident angle high-speed spectroscopic ellipsometer (e.g., M-2000, available from J.A. Woollam Company) and calculating a refractive index at a wavelength of 589 nm therefrom.

The material of the optical adjustment layer may be any material as long as it satisfies such a refractive index. For example, the material may be a material having a refractive index adjusted by adding metal oxide particles to the curable composition exemplified as the material of the hard coat layer. The metal oxide particles are preferably a refractive index material having a refractive index of 1.50 or more. Examples of such metal oxide particles include aluminum oxide, titanium oxide, zirconium oxide, zinc oxide, and tin oxide. Among these, titanium oxide and zirconium oxide are preferable.

The thickness of the optical adjustment layer is not particularly limited, but only needs to be 0.050 µm or more. For example, the thickness of the optical adjustment layer may be 0.050 µm or more and 0.50 µm or less, or may be 0.080 µm or more and 0.18 µm or less. When the thickness of the optical adjustment layer is within the above range, the color tone of the laminated piezoelectric body can be further improved.

As illustrated in FIG. 3, the laminated piezoelectric body 10 may further include a transparent conductive film 16 (a laminate of a base film 16a and a transparent electrode 16b) on the other surface of the piezoelectric film 11 (the surface opposite to the surface on which the antistatic layer 12 is disposed) with a transparent adhesive layer 17 interposed therebetween.

### EXAMPLES

Hereinafter, the present invention will be further described with reference to Examples and Comparative Examples. The technical scope of the present invention is not limited to these.

### 1. Evaluation of Physical Properties

### (1) Thickness of Each Layer

The thickness of each layer was measured using a spectral interference-type thickness meter (Optical NanoGauge C13027-11, available from Hamamatsu Photonics K.K.). The thickness of each layer in a region including the center of the surface of the laminated piezoelectric body was measured at 3 points, and the arithmetic average value thereof was calculated.

### (2) Surface Resistivity

The surface resistivity on the antistatic layer was measured with a high resistivity meter (available from Nitto Seiko Analytech Co., Ltd., Hiresta-UX, model number: MCP-HT800) using a URS probe.

### 2. Production and Evaluation of Laminated Piezoelectric Body

### Example 1

### (1) Production of Piezoelectric Film

A polyvinylidene fluoride film (available from KUREHA CORPORATION, containing 100 mass% of a vinylidene fluoride homopolymer) was stretched in the MD direction to a stretching ratio of 4.2 times, and then the film was subjected to a polarization treatment by applying a DC voltage between a ground electrode and a needle-shaped electrode while the DC voltage was increased from 0 kV to 11.0 kV to produce a piezoelectric film having a thickness of 42 µm.

### (2) Formation of Antistatic Layer

A solution containing an aqueous dispersion of carbon nanotube and a melamine resin was applied to the A surface of the produced piezoelectric film with a multicoater (available from Hirano Tecseed Co., Ltd.), and the resultant product was subjected to heat treatment at 130°C for 1 minute to form an antistatic layer having a thickness of 0.050 µm.

### (3) Formation of Hard Coat Layer

An ultraviolet-curable composition containing an acrylic compound and amorphous silica was applied onto the resultant antistatic layer with a multicoater, and then the resultant product was subjected to heat treatment at 80°C for 2 minutes, and further irradiated with UV at an integrated light quantity of 400 mJ/cm² to be photocured, to thereby form a hard coat layer having a thickness of 0.70 µm.

### (4) Formation of Moisture-Proof Layer

A silicon dioxide (SiO₂) film was formed on the resultant hard coat layer by reactive sputtering to form a moisture-proof layer having a thickness of 0.025 µm. Thus, a laminated piezoelectric body having a laminated structure of piezoelectric film/antistatic layer/hard coat layer/moisture-proof layer was produced.

### Example 2

A laminated piezoelectric body was produced in the same manner as in Example 1, except that the thickness of the moisture-proof layer was changed to 0.020 µm.

### Example 3

A laminated piezoelectric body was produced in the same manner as in Example 1, except that the thickness of the moisture-proof layer was changed to 0.040 µm.

### Example 4

The production of a piezoelectric film, the formation of an antistatic layer, and the formation of a hard coat layer were performed by the same method as in Example 1.

An ultraviolet-curable composition containing an acrylic compound and zirconium oxide particles was applied onto the resultant hard coat layer with a multicoater, and the resultant coating film was dried by heating at 80°C for 2 minutes. Thereafter, the coating film was irradiated with ultraviolet light at an integrated light quantity of 400 mJ/cm² to be photocured, to thereby form an optical adjustment layer having a thickness of 0.10 µm.

An indium tin oxide film was formed on the resultant optical adjustment layer by reactive sputtering to form a moisture-proof layer having a thickness of 0.030 µm, to thereby produce a laminated piezoelectric body.

### Example 5

A laminated piezoelectric body was produced in the same manner as in Example 4, except that the thickness of the antistatic layer was changed to 0.38 µm.

### Comparative Example 1

A laminated piezoelectric body was produced by the same method as in Example 1, except that the hard coat layer and the moisture-proof layer were not formed.

### Comparative Example 2

A laminated piezoelectric body was produced by the same method as in Example 5, except that the hard coat layer, the optical adjustment layer, and the moisture-proof film were not formed.

### Comparative Example 3

A laminated piezoelectric body was produced by the same method as in Example 5, except that the optical adjustment layer and the moisture-proof layer were not formed.

### Evaluation

### (1) Piezoelectric Constant

The piezoelectric constant d₃₃ was measured in accordance with ISO 19622:2018, which is a test method for the piezoelectric constant d₃₃ of piezoelectric ceramics by a direct quasi-static method (d₃₃ meter method, Berlincourt method). Specifically, the piezoelectric constant d₃₃ of a laminated piezoelectric body was measured with a piezoelectric constant measuring device (PiezoMeter System PM300, available from PIEZOTEST Pte Ltd.) by clipping a sample at 1.0 N and reading a charge generated under application of a force of 0.15 N and 110 Hz. The actual measurement value of the piezoelectric constant d₃₃ at a measurement temperature of 25°C is a positive value or a negative value, depending on whether the front or back side of the film is measured. In the present specification, the absolute value is used as the magnitude of the piezoelectric constant.

### (2) Water Vapor Permeability

The water vapor permeability of a laminated piezoelectric body was measured under the condition of 40°C and 90% RH using a water vapor permeability measurement device (Aqua Sense Model 7101, available from Systech Illinois) based on JIS K7129-2.

### (3) Total Light Transmittance

The total light transmittance of a laminated piezoelectric body was measured using a haze meter (NDH7000SP II, available from Nippon Denshoku Industries Co., Ltd.) based on the method described in JIS K 7361-1.

### (4) Hue Difference Δb^{*} Value

The hue b^{*} value of a laminated piezoelectric body before storage under moist heat was measured by a method in accordance with JIS Z 8722 using a spectral colorimeter (SD7000, available from Nippon Denshoku Industries Co., Ltd.).

Next, the laminated piezoelectric body was cut into a square of 25 cm², four corners of the laminated piezoelectric body were fixed to a plate made of SUS with a tape, the laminated piezoelectric body was placed in a thermo-hygrostat (LH44-14, available from Nagano Science Co., Ltd.) set to a temperature of 85°C and a relative humidity of 85% RH, the laminated piezoelectric body was held under the above conditions for 500 hours, the laminated piezoelectric body was taken out from the thermo-hygrostat, and the hue b^{*} value of the laminated piezoelectric body after the storage was measured in the same manner as in the above method.

The difference between the hue b^{*} value after the storage and the hue b^{*} value before the storage was defined as a Δb^{*} value.

The evaluation results of the laminated piezoelectric bodies of Examples 1 to 5 and Comparative Examples 1 to 3 are shown in Table 1.

**[Table 1]**

| | | | Example 1 | Example 2 | Example 3 | Example 4 | Example 5 | Comparative Example 1 | Comparative Example 2 | Comparative Example 3 |
|---|---|---|---|---|---|---|---|---|---|---|
| Configuration | Antistatic layer | Thickness (µm) | 0.050 | 0.050 | 0.050 | 0.050 | 0.38 | 0.050 | 0.38 | 0.38 |
| | | Surface resistivity (Ω/sq.) | 7.6 × 10⁶ | 7.6 × 10⁶ | 7.6 × 10⁶ | 7.6 × 10⁶ | 6.9 × 10⁵ | 7.6 × 10⁶ | 6.9 × 10⁵ | 6.9 × 10⁵ |
| | Hard coat layer | Thickness (µm) | 0.70 | 0.70 | 0.70 | 0.70 | 0.70 | - | - | 0.70 |
| | Optical adjustment layer | Thickness (µm) | - | - | - | 0.10 | 0.10 | - | - | - |
| | Moisture-proof layer | Thickness (µm) | 0.025 | 0.020 | 0.040 | 0.030 | 0.030 | - | - | - |
| Evaluation | Piezoelectric constant d₃₃ (pC/N) | | 18.1 | 18.1 | 18.1 | 18.1 | 20.8 | 18.1 | 21.1 | 20.0 |
| | Water vapor permeability (g/m²/day/atm) | | 0.38 | 0.57 | 0.15 | 0.28 | 0.28 | 7.1 | 7.1 | 7.0 |
| | Total light transmittance (%) | | 91.6 | 91.2 | 92.8 | 87.7 | 84.6 | 89.2 | 85.6 | 86.1 |
| | Hue b* (-) before high-temperature high-humidity test | | 0.3 | 0.1 | 2.7 | 1.8 | 2.1 | 1.4 | 1.3 | 0.3 |
| | Hue difference Δb* (-) before and after high-temperature high-humidity test | | 3.3 | 2.9 | 1.8 | 2.3 | 3.7 | 5.6 | 9.4 | 8.9 |

As shown in Table 1, it is found that each of the laminated piezoelectric bodies of Comparative Examples 1 to 3 including no moisture-proof layer exhibits a large change in hue. In contrast, it is found that each of the laminated piezoelectric bodies of Examples 1 to 5 including the moisture-proof layer exhibits a small change in hue.

These results indicate that the discoloration of the piezoelectric film in the laminated piezoelectric body is suppressed by including the moisture-proof layer, which can reduce a change in the hue of the laminated piezoelectric body.

The present application claims priority to Japanese Patent Application No. 2023-216252 filed on December 21, 2023. The content described in the specifications and drawings of the priority application is incorporated herein by reference in its entirety.

### INDUSTRIAL APPLICABILITY

According to the laminated piezoelectric body of the present invention, the discoloration of the piezoelectric film is small even under high temperature and high humidity, and high transparency can be maintained. Thus, the laminated piezoelectric body can be suitably used as a piezoelectric sensor of a touch panel.

### REFERENCE SIGNS LIST

10 Laminated piezoelectric body
11 Piezoelectric film
12 Antistatic layer
13 Hard coat layer
14 Moisture-proof layer
15 Optical adjustment layer
16 Transparent conductive film
16a Base film
16b Transparent electrode
17 Transparent adhesive layer

## Claims

1. A laminated piezoelectric body comprising:
a piezoelectric film containing a fluorine-based resin as a main component;
an antistatic layer disposed on at least one surface of the piezoelectric film; and
a moisture-proof layer disposed on a side opposite to the piezoelectric film such that the antistatic layer is interposed between the moisture-proof layer and the piezoelectric film, wherein
the laminated piezoelectric body has a water vapor permeability of 0.00 g/m²/day/atm or more and 4.00 g/m²/day/atm or less under an environment of 40°C and 90% RH.

2. The laminated piezoelectric body according to claim 1, wherein
no adhesive layer is disposed between the antistatic layer and the moisture-proof layer.

3. The laminated piezoelectric body according to claim 1 or 2, wherein
the antistatic layer contains a cured product of a curable composition containing a conductive material and an amine-based material.

4. The laminated piezoelectric body according to any one of claims 1 to 3, wherein
the moisture-proof layer is formed of an inorganic oxide.

5. The laminated piezoelectric body according to any one of claims 1 to 4, further comprising
at least one of a hard coat layer or optical adjustment layer disposed between the antistatic layer and the moisture-proof layer.

6. The laminated piezoelectric body according to claim 5, wherein
a total thickness of the hard coat layer and the optical adjustment layer is 0.30 µm or more and 4.0 µm or less.

7. The laminated piezoelectric body according to any one of claims 1 to 6, wherein
when the laminated piezoelectric body is held under an environment of 85°C and 85% RH for 500 hours, a hue difference Δb^{*} before and after the holding under the environment is 4.0 or less.

8. The laminated piezoelectric body according to any one of claims 1 to 7, wherein
the antistatic layer has a thickness of 0.010 µm or more and 0.40 µm or less.

9. The laminated piezoelectric body according to any one of claims 1 to 8, wherein
the fluorine-based resin contains a polymer containing a constituent unit derived from vinylidene fluoride as a main component.

10. A method for producing the laminated piezoelectric body described in any one of claims 1 to 9, the method comprising:
applying a curable composition containing a conductive material and an amine-based material onto the piezoelectric film and then curing the curable composition to form an antistatic layer; and
forming a moisture-proof layer on the antistatic layer by reactive sputtering.
